# EUROPEAN PATENT APPLICATION

(11) **EP 1 255 284 A1**
(43) Date of publication of application: **06.11.2002**
(21) Application number: 01951942.0
(22) Date of filing: 19.07.2001
(51) Int. Cl.: H01L 21/02, H01L 21/68, H05B 3/20

(54) **SEMICONDUCTOR MANUFACTURING/TESTING CERAMIC HEATER**

(30) Priority: 19.07.2000 JP 2000219671; 13.09.2000 JP 2000278772
(71) Applicant: IBIDEN CO., LTD., Ogaki-shi Gifu-ken 503-0917 (JP)
(72) Inventor: ITO, Atsushi, Ibi-gun, Gifu 501-0695 (JP); KARIYA, Satoru, Ibi-gun, Gifu 501-0695 (JP)
(74) Representative: Forstmeyer, Dietmar, Dr. rer. nat., Dipl.-Chem.
(86) International application number: JP0106288
(87) International publication number: WO02007196

(57) **Abstract**

An object of the present invention is to provide a ceramic heater for a semiconductor producing/examining device wherein a scattering in the resistance value of its resistance heating element is hardly generated and its heating face is excellent in temperature evenness. The present invention is a ceramic heater for a semiconductor producing/examining device having a resistance heating element formed on a surface of a ceramic substrate, wherein a gutter is formed along the direction of current flowing through the resistance heating element.

## Description

### Technical Field

The present invention relates to a ceramic heater (hot plate) for a semiconductor producing/examining device used mainly to produce or examine a semiconductor.

### Background Art

Hitherto, a heater, a wafer prober and the like wherein a base material made of metal such as stainless steel or aluminum alloy is used has been used as a semiconductor producing/examining device and the like, examples of which include an etching device and a chemical vapor deposition device.

However, a heater made of metal has a thick heater plate; therefore, the heater has such problems that the heater has a large weight and is bulky. Furthermore, these problems result in a problem about its temperature-rising/temperature-dropping properties.

Thus, JP Kokai Hei 11-40330 discloses a ceramic heater for a semiconductorproducing/examining devicewherein a nitride ceramic or a carbide ceramic, which has a high heat conductivity and a large intensity, is used as a substrate and resistance heating elements formed by sintering metal particles are set up on the surface of a plate formed body made of such a ceramic (ceramic substrate).

Examples of the method of forming the resistance heating elements when such a ceramic heater for a semiconductor producing/examining device is manufactured include the following methods.

A ceramic substrate having a given shape is first manufactured. In the case that resistance heating elements are formed by coating method after the manufacturing of the ceramic substrate, a conductor containing paste layer having a heating element pattern is formed on the surface of this ceramic substrate by such a method as screen printing and then the paste layer is heated and fired, thereby forming the resistance heating elements.

In the case that resistance heating elements are formed by a plating method or a physical vapor deposition method such as sputtering, a metal layer is formed on a given area on a ceramic substrate by the above-mentioned method and subsequently the resistance heating elements having a given pattern are formed by making an etching resist to cover a heating element pattern portion and then conducting an etching treatment.

Resistance heating elements having a given resistance heating element pattern can also be formed on the surface of a ceramic substrate through one processing by covering portions other than the heating element pattern with resin and the like and subsequently conducting above-mentioned treatment.

### Summary of the Invention

In the method of sputtering, plating and the like, a precise pattern can be formed. However, in order to form the resistance heating elements having the given pattern, it is necessary to form an etching resist, a plating resist and the like on the surface of the ceramic substrate by photolithography. Thus, a problem that the manufacturing costs become expensive arises.

On the other hand, in the method using a conductor containing paste, resistance heating elements can be formed at a relatively low cost by using such a manner as screen printing and the like, as described above. However, in the case of attempting to form a minute pattern, a short-circuit and the like is caused by a trifling mistake at the time of the printing. As a result, a problem that resistance heating elements having a minute pattern are not easily formed is caused. Moreover, this method has a problem that the thickness of the printed matter is scattered to result in a scattering in the resistance value.

Thus, the present inventors have hit on an idea that the resistance value is adjusted by performing trimming in order to suppress such a scattering in the resistance value of resistance heating elements.

Furthermore, the inventors have researched a trimming shape, and then obtained a new finding on a preferable trimming shape and completed the present invention.

That is, the present invention is a ceramic heater, for a semiconductor producing/examining device, comprising a ceramic substrate and a resistance heating element formed on a surface thereof, wherein a gutter is formed along the direction of current flowing through the resistance heating element.

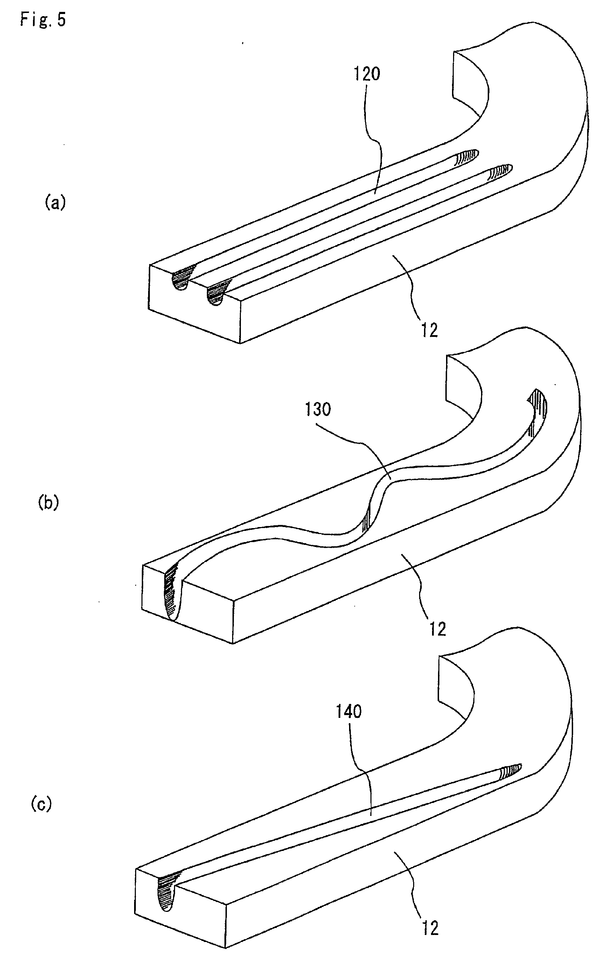

As illustrated in Fig. 5(a), when gutters 120 resulting from trimming are formed in substantially parallel to the direction of current flowing through a resistance heating element 12, the resistance value thereof does not become locally large.

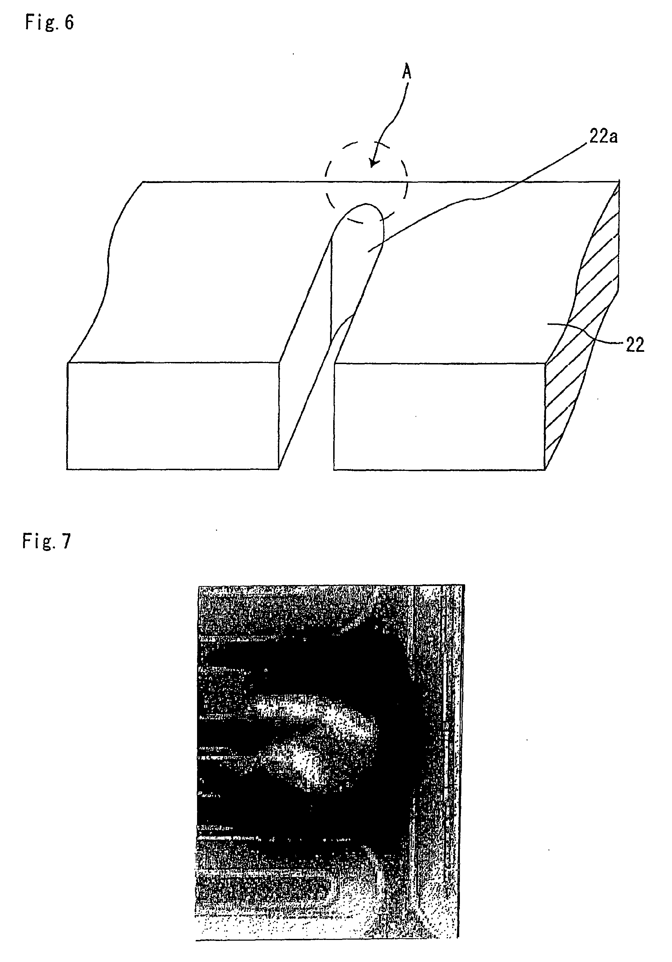

As illustrated in Fig. 6, in the case that the resistance heating element 22 is trimmed perpendicularly to the direction of current flowing through the resistance heating element 22 to form a cut 22a, the resistance value of a portion A of the resistance heating element 22 becomes extremely high. As a result, the resistance heating element 22 is melted by heat, as illustrated in Fig. 7. However, in the present invention, such extreme heat is not generated so that damage based on the overheating of the resistance heating element is not caused. Moreover, an extreme rise in the resistance value is not caused so that a scattering in the resistance value can be made very small, i.e., 5% or less.

It is unnecessary that a current-conducting direction and a gutter-formed direction are mathematically parallel to each other. As illustrated in Fig. 5 (b), a groove 130 may be formed to be drawn as a curved line. As illustrated in Fig. 5(c), a groove 140 may be formed to be drawn as an oblique line to the current-conducting direction. In short, it is necessary and sufficient if the direction of the gutter is parallel to the current-conducting direction or if the angle between the current-conducting direction and the gutter-formed direction is an acute angle.

The scattering in the resistance value of the resistance heating element can be made small in this way; therefore, even in case the resistance heating element is divided to plural circuits and controlled, the number of the divided circuits can be reduced and the resistance value of the circuits can easily be controlled. When the scattering in the resistance value is large, it is necessary that the resistance heating element is divided to small circuits and the electric powers to be applied to the respective circuits (channels) are varied dependently on the respective circuits to carry out temperature-control. In the present invention, however, a scattering in the resistance value is hardly generated. It is therefore unnecessary to divide the resistance heating element to small pieces. Thus, control is easily performed. Furthermore, temperature on a heating face can be made even at a transient time at the time of a temperature-rise.

Also, in the case that the resistance heating element is trimmed by a laser perpendicularly to the direction of current flowing through, the laser is applied to the surface of the ceramic substrate. As a result, the ceramic substrate gets colored to result in poor appearance and a drop in the strength of the ceramic.

However, if a gutter is formed in substantially parallel to the direction of current flowing through the resistance heating element, the colored portion is hidden and further a drop in the strength of the ceramic substrate can be prevented because excessive heat energy does not conduct to the ceramic substrate.

The above-mentioned gutter resulting from trimming has desirably a depth of 20% or more of the thickness of the resistance heating element, and more desirably a depth of 50% or more. This is because if the depth is less than 20% of the thickness, a change in the resistance value is hardly caused.

The width of the resistance heating element is desirably 0.5 mm or more. If the width is less than 0.5 mm, the resistance heating element is too fine so that the resistance heating element is not easily trimmed in substantially parallel to the direction of current flowing through the resistance heating element.

In the present invention, the resistance heating element is formed, on the substrate, from a conductor containing paste containing a metal or a metal and an oxide; therefore, the resistance heating element is easily trimmed particularly with a laser. This is because metal is evaporated and removed but ceramic is not easily removed. Accordingly, the present invention is entirely different from laser trimming on a semiconductor wafer or a print circuit board, and the trimming wherein the adjustment of laser power is not required; and precise trimming wherein removal residues are not generated; can be realized. Furthermore, since the ceramic substrate is used, the substrate is not warped or the strength thereof is not markedly lowered by the above-mentioned trimming.

The present invention will be described by way of embodiments hereinafter.

### Brief Description of Drawings

Fig. 1 is a bottom view which schematically illustrates an example of the ceramic heater for a semiconductor producing/examining device of the present invention.
Fig. 2 is a partially-enlarged sectional view of the ceramic substrate illustrated in Fig. 1.
Fig. 3 is a block diagram showing the general construction of a laser trimming equipment used when a ceramic heater for a semiconductor producing/examining device according to the present invention is manufactured.
Fig. 4 is a perspective view which schematically illustrates a table constituting the laser trimming equipment illustrated in Fig. 3.
Figs. 5(a) to (c) are perspective views, each of which schematically illustrates a resistance heating element wherein a gutter or gutters is/are formed in substantially parallel to a current-flowing direction by trimming.
Fig. 6 is a perspective view which schematically illustrates a resistance heating element wherein a gutter is formed by trimming perpendicular to a current-flowing direction.
Fig. 7 is a photograph showing a melted resistance heating element.
Fig. 8 is a perspective view which illustrates a situation that a resistance heating element is divided to plural areas to measure the resistance value thereof.
Fig. 9 is a graph showing the shape (position and height) of a section of a resistance heating element.
Figs. 10 (a) to (d) are sectional views illustrating steps for manufacturing resistance heating elements of the present invention.

### Explanation of Symbols

- 11: ceramic substrate
- 11: heating face
- 11b: bottom face
- 12(12a to 12g): resistance heating element
- 12m: conductor layer
- 13: table
- 13a: fitting projection
- 13b: fixing projection
- 14: laser radiation equipment
- 15: galvano mirror
- 16: motor
- 17: control unit
- 18: memory unit
- 19: operation unit
- 20: input unit
- 21: camera
- 22: laser ray
- 30: ceramic heater
- 33: external terminal
- 34: bottomed hole
- 35: through hole
- 36: lifter pin
- 39: silicon wafer

### Detailed Disclosure of the Invention

The ceramic heater of the present invention is a ceramic heater, for a semiconductor producing/examining device, comprising a ceramic substrate and a resistance heating element formed on a surface thereof, wherein a gutter is formed along the direction of current flowing through the resistance heating element.

The ceramic heater for a semiconductor producing/examining device may be referred to merely as the ceramic heater hereinafter.

This ceramic heater is made as follows: the face opposite to its heating element-formed face is a heating face; a gutter is formed in the resistance heating element by trimming; and the resistance value of the whole of the resistance heating element is adjusted so that a temperature distribution on the heating face becomes even.

The trimming can be performed by irradiation with a laser ray, a grinding treatment with sandblast, a grinding treatment with a belt sander, and the like.

The laser ray which can be used may be, for example, a YAG laser, an excimer laser (KrF) or a carbon dioxide gas laser and the like.

The gutter formed by triming is formed in a upper surface of the resistance heating element. This is because if the gutter formed by triming is formed in a side face of the resistance heating element, a portion having a locally high resistance is generated so that the portion is melted by heat. Figs. 5(a) to (c) are perspective views, each of which schematically illustrates a resistance heating element 12 wherein its upper surface is trimmed in substantially parallel to a current-flowing direction. Gutters 120, 130 and 140 formed by trimming are in a straight line or curved line form, as illustrated in Fig. 5. Plural gutters in a straight line or curved line form may be formed.

In the case that the resistance heating element is formed to be drawn as a arc, the resistance value thereof can be more largely changed by trimming the inner side of the arc resistance heating element. This is because current tends to flow more easily in the inner side.

The gutter desirably has a depth of 20% or more of the thickness of the resistance heating element because the resistance value thereof can be changed largely.

If the depth of the gutter is less than 20%, the resistance value hardly changes.

About a scattering in the resistance value of the resistance heating element, a resistance value scattering to the average resistance value is desirably 5% or less, more desirably 1% or less. Even when the resistance heating element is divided to plural circuits and the resistance values of the respective circuits are controlled, the number of the divided circuits can be reduced by making the scattering small in the above-mentioned manner. Thus, the control can be made easy. Moreover, the temperature on the heating face at a transient time at the time of a temperature-rise can be made even.

The scattering in the resistance value of the resistance heating element is desirably to be suppressed into 25% or less by making the thickness, the width and the like thereof uniform when the resistance heating element is printed, and then to be suppressed into 5% or less by further trimming. This is because if the scattering is made smaller at the stage of printing the resistance heating element, adjustment based on trimming is made easier.

The width of the gutter is desirably from 1 to 100 µm. If the width is over 100 µm, disconnection and the like is easily caused. On the other hand, if the width is less than 1 µm, it is difficult to adjust the resistance value of the resistance heating element. The spot diameter of the laser ray is adjusted to 1 µm to 2 cm.

The trimming is desirably performed on the basis of a value obtained by measuring the resistance value of the resistance heating element. This is because the resistance value can be precisely adjusted.

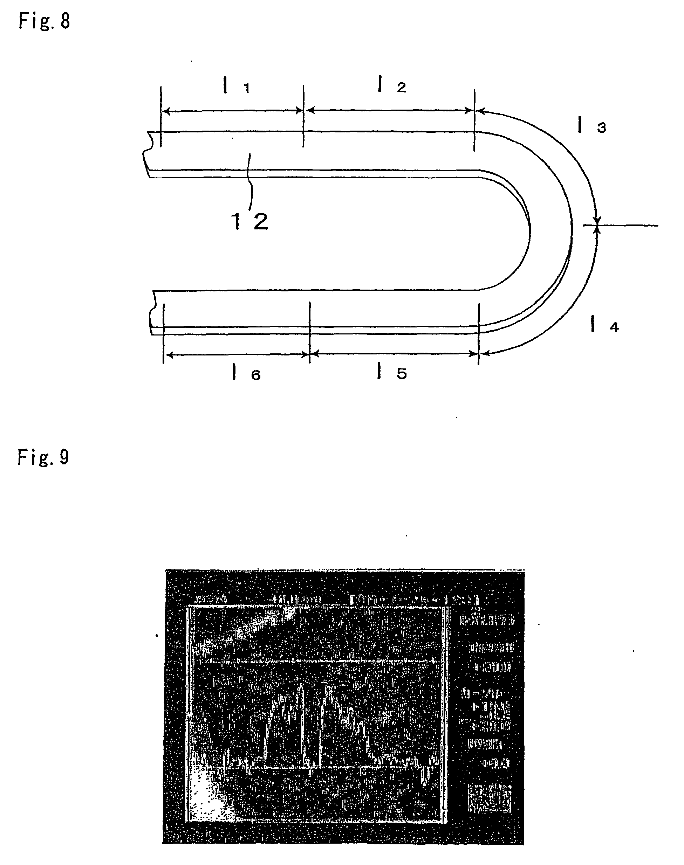

In the measurement of the resistance value, for example, the pattern of the resistance heating element is divided to sections l₁ to l₆ and then the resistance values of the respective sections are measured, as illustrated in Fig. 8. The section having a low resistance value is subjected to trimming treatment.

After the trimming treatment, the resistance value is again measured and, if necessary, trimming is further performed. That is, such resistance-value-measurement and trimming may be performed one time or may be performed two times or more.

The trimming is desirably performed after a paste for the resistance heating element is printed and then fired. This is because the resistance value may vary by the firing or the paste may exfoliate on account of irradiation with the laser ray.

First, the resistance heating element paste may be printed on a stretching surface (in the so-called spread state), and then patterned by trimming. If the paste is printed into a pattern at an initial stage, a scattering in the thickness thereof is generated in the printing direction. However, when the paste is printed on a stretching surface, the paste can be printed to have an even thickness. As a result, by trimming this into a pattern, a heating element pattern having an even thickness can be obtained.

The following will describe a trimming system of the present invention.

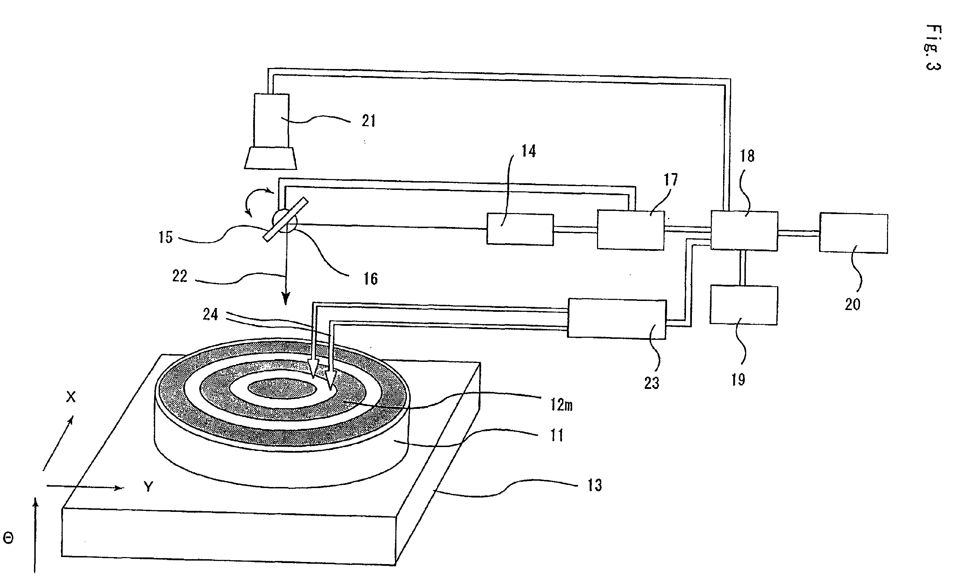

Fig. 3 is a block diagram illustrating the general construction of a laser trimming equipment used to manufacture a ceramic heater of the present invention.

As illustrated in Fig. 3, when laser trimming is performed, the following is fixed onto a table 13: a disk-form ceramic substrate 11, on which a conductor layer 12m is formed into a concentric circular shape having a given width in such a manner that the layer 12m includes circuits of resistance heating element to be formed, or on which resistance heating elements having a given pattern are formed.

This table 13 is provided with a motor etc. (not illustrated) and further the motor etc. are connected to a control unit 17. By driving the motor etc. through signals from the control unit 17, the table 13 can freely be moved into xy directions (or additionally a θ direction).

A galvano mirror 15 is set up above this table 13. This galvano mirror 15 can freely be rotated with the motor 16. A laser ray 22 emitted from a laser radiation equipment 14 arranged above the table 13 similarly is applied to this galvano mirror 15 and reflected thereon. The reflected ray is applied to a ceramic substrate 11.

The motor 16 and the laser radiation equipment 14 are connected to the control unit 17. By driving the motor 16 and the laser radiation equipment 14 through signals from the control unit 17, the galvano mirror 15 is rotated by a given angle. Thus, the position irradiated with the laser ray can freely be set along the x-y directions on the ceramic substrate 11.

By moving the table 13 on which the ceramic substrate 11 is put and/or the galvano mirror 15 in this way, an arbitrary position on the ceramic substrate 11 can be irradiated with the laser ray 22.

A camera 21 is also set up above the table 13. In this way, the position (x, y) of the ceramic substrate 11 can be recognized. This camera 21 is connected to a memory unit 18, thereby recognizing the position (x, y) of the conductor layer 12m of the ceramic substrate 11. Thus, the position is irradiated with the laser ray 22.

An input unit 20 is connected to the memory unit 18, and has a keyboard etc. (not illustrated) as a terminal. Given instructions are inputted through the memory unit 18, keyboard etc. to the input unit 20.

Furthermore, this laser trimming equipment is provided with an operation unit 19, which calculates the position irradiated with the laser ray 22, radiation speed, the intensity of the laser ray, etc. on the basis of data on the position and the thickness of the ceramic substrate 11 recognized by the camera 21, and the like data. On the basis of results of this calculation, instructions are supplied from the control unit 17 to the motor 16, the laser radiation equipment 14, and the like, to apply the laser ray 22 to given positions while rotating the galvano mirror 15 or moving the table 13. In this way, unnecessary portions of the conductor layer 12m are trimmed, or portions in substantially parallel to the direction of current flowing through the resistance heating element pattern are trimmed.

This laser trimming equipment has a resistance measuring section. The resistance measuring section has tester pins, and the resistance heating element pattern is divided to plural sections. The tester pins are brought into contact with the respective sections and the resistance values of the resistance heating elements are measured. A laser ray is applied to the sections to perform trimming in substantially parallel to the direction of current flowing through the resistance heating elements.

The following will specifically describe a process for manufacturing a ceramic heater, using such a laser trimming equipment. Herein, a laser trimming step, which is an important step of the present invention, will be detailed, and steps other than the trimming step will briefly be described. These steps other than the trimming step will be described in more detail later.

First, a ceramic substrate is manufactured. A raw formed body made of ceramic powder and resin is first produced. The method of producing this raw formed body is a method of producing granules containing ceramic powder and resin, putting the granules into a molding and the like, and applying pressing pressure thereto, or a method of producing the raw formed body by laminating green sheets and then compressing the resultant lamination. A more appropriate method is selected depending on whether or not other conductor layers such as electrostatic electrodes are formed. Thereafter, the raw formed body is degreased and fired to manufacture a ceramic substrate.

Thereafter, through holes, into which lifter pins will be inserted, and bottomed holes, in which temperature-measuring elements will be embedded, are formed in the ceramic substrate.

Next, a conductor containing paste layer having a shape as illustrated in Fig. 3 is formed on this ceramic substrate 11 and in a wide area including portions which will be resistance heating elements. The resultant is fired to form a conductor layer 12m.

The conductor layer may be formed by a plating method or a physical vapor deposition method such as sputtering and the like. In the case of plating, a plating resist is formed. In the case of sputtering, selective etching is performed. Thus, the conductor layer 12m can be formed in the given area.

The conductor layer may be formed as a resistance heating element pattern, as described above.

In this way, the ceramic substrate 11 on which the conductor layer 12m is formed in the given area or the resistance heating elements having a given pattern are formed is fixed onto a given position in the table 13.

Trimming data, data on the resistance heating element pattern, both of them, and the like are beforehand inputted from the input unit 20, and stored in the memory unit 19. That is, data on the shape to be formed by trimming are before hand memorized. The trimming data are data used when trimming of the side face or the upper surface of the resistance heating element pattern, trimming in the thickness direction, trimming of a pattern in a ladder form, and the like trimming is performed. The data on the resistance heating element pattern are used when the conductor layer printed on a stretching surface (in the so-called spread state) is trimmed to form the resistance heating element pattern. Of course, these can be used together.

In addition to these data, desired resistance value data may be inputted and stored in the memory unit. This process comprises the steps of measuring the resistance value actually in the resistance measuring section, calculating a difference thereof from a desired resistance value, calculating how to perform trimming in order to amend this actual value to the desired resistance value, and generating control data.

Next, the fixed ceramic substrate 11 is photographed with the camera 21 to memorize the position where the conductor layer 12m should be formed and the pattern of the resistance heating elements in the memory unit 18.

On the basis of the data on the position of the conductor layer, data on the shape to be formed by trimming, and the optional data on the resistance value, calculations are carried out in the operation unit 19. The results are memorized as control data in the memory unit 18.

On the basis of the calculation results, control signals are generated from the control unit 17 to apply a laser ray while driving the motor 16 for the galvano mirror 15, and/or the motor for the table 13. In this way, unnecessary portions in the conductor layer 12m or resistance heating element portions where their resistance is required to be raised are trimmed by the above-mentioned method.

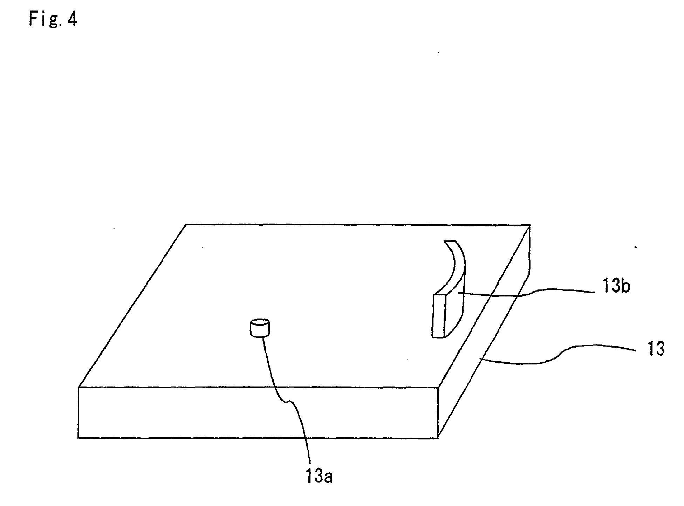

As illustrated in Figs. 3 and 4, the table 13 has the fixing projection 13b which contacts the side face of the ceramic substrate 11, and the fitting projection 13a which is fitted into the through hole into which a lifter pin will be inserted. These projections are used to fix the ceramic substrate 11 onto the table 13a.

Thereafter, through the steps of connecting external terminals and setting temperature-measuring elements, and the like steps, the manufacture of a ceramic heater finishes.

About the resistance value control, the resistance heating element pattern is divided to 2 or more sections (l₁ to l₆) and the resistance values of the respective sections are controlled, as illustrated in Fig. 8.

As illustrated in Figs. 5, in the present invention, gutters 120 are formed in substantially parallel to the direction of current flowing through the resistance heating element 12, thereby controlling the resistance value.

When unnecessary portions of the conductor layer etc. are removed, portions to be trimmed in the conductor layer etc. are trimmed by application of a laser ray thereto. It is however important that the application of the laser ray does not produce a large effect on the ceramic substrate present below the portions to be trimmed.

It is therefore necessary to select a laser ray which is satisfactorily absorbed in metal particles etc. which constitute the conductor layer etc. but is not easily absorbed in the ceramic substrate. The kind of such a laser ray may be, for example, a YAG laser, a carbon dioxide layer, an excimer layer or UV (ultraviolet) laser and the like, as described above.

Among these lasers, the YAG layer and the excimer (KrF) layer are best.

The ceramic substrate 11 is preferably made of a material in which a laser ray is not easily absorbed. In the case of, for example, an aluminum nitride substrate, aluminum nitride whose carbon content is as small as 5000 ppm or less is preferable. The surface roughness of the surface is desirably set to 20 µm or less as the Ra according to JIS B0601. This is because when the surface roughness is large, a laser ray is absorbed thereon.

The YAG laser which can be adopted is, for example, SL432H, SL436G, SL432GT, SL411B and the like, made by NEC Corp.

The laser is desirably a pulse ray. This is because the pulse ray makes it possible to apply a large energy to the resistance heating element in a very short time and make damage against the ceramic substrate small. The pulse is desirably 1 kHz or less. This is because if the pulse is more than 1 kHz, the energy of a first pulse of the laser is high so that excessive trimming is performed.

Working speed is desirably 100 mm/second or less. If the working speed is more than 100 mm/second, no gutter can be formed so far as the frequency is not made high. Since the upper limit of the frequency is 1 kHz or less as described above, the working speed is desirably 100 mm/second or less.

Furthermore, in the case that the resistance heating element is completely caused to disconnect, the power of the laser is desirably 0.3 W or more.

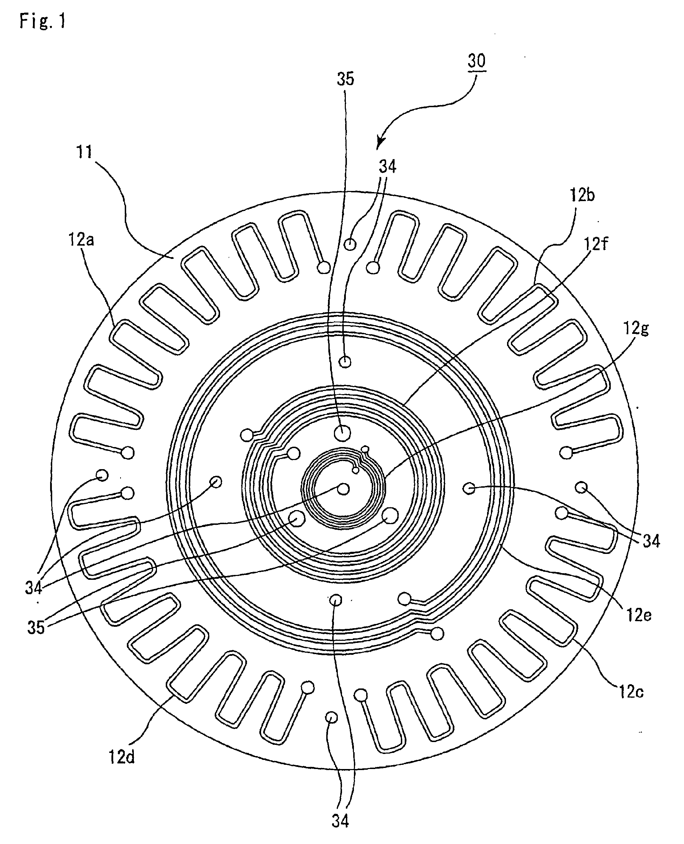

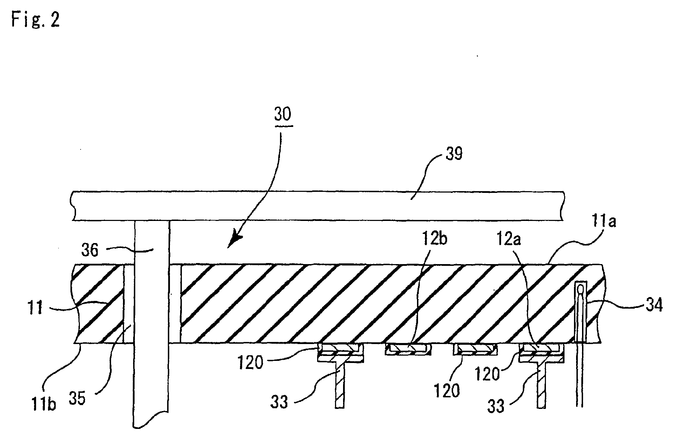

Fig. 1 is a bottom view which schematically illustrates a ceramic heater 30 having resistance heating elements 12 (12a to 12d) trimmed by the above-mentioned method, and Fig. 2 is a partially enlarged sectional view thereof.

In this ceramic heater 30, the resistance heating elements 12 (12a to 12d) are composed of a pattern having a form of concentric circles and a pattern having a form of winding lines on a bottom face 11b of a ceramic substrate 11, in order to perform heating in such a manner that the temperature of the whole of the wafer-heating face 11a will be even.

In this ceramic heater 30, through holes 35, into which lifter pins 36 for carrying a silicon wafer 39 will be inserted, are made near the center. Furthermore, bottomed holes 34, into which temperature-measuring elements will be inserted are also formed.

The resistance heating elements 12 are covered with a metal covering layer 120, so as to be protected. External terminals 33 are connected to ends of the resistance heating elements 12 through a solder layer (not illustrated) and the like.

In the ceramic substrate 30 of the present invention, an object to be heated, such as the silicon wafer 39 and the like, is put on the heating face 11a of the ceramic substrate 11 in the state that they contact each other, and is then heated. Besides, it is allowable to make through holes or concave portions in the ceramic substrate, insert and fix supporting pins whose tips are in a pointed end form or semicircular form into the concave portions and the like in the state that the tips are slightly projected from the ceramic substrate surface, and support the object to be heated such as the silicon wafer 39 by the supporting pins, thereby holding the object in the state that a constant interval is kept between the obj ect and the ceramic substrate.

The distance between the heating face and the wafer is preferably from 5 to 5000 µm.

By inserting the lifter pins into the through holes and moving the lifter pins 36 up and down, it.is possible to receive the object to be heated such as the silicon wafer 39 from a carrier machine, put the object on the ceramic substrate 11, or heat the object while supporting the object.

In the case that a resistance heating element is formed on the surface (bottom face) of a ceramic substrate as is in the ceramic heater of the present invention, the heating face thereof is desirably present at the side opposite to the face on which the resistance heating element is formed. This is because the temperature-evenness on the heating face can be improved since the ceramic substrate acts to attain heat diffusion.

The ceramic substrate in the ceramic heater of the present invention is desirably in a disc form. The diameter thereof is desirably more than 190 mm. This is because a scattering in the temperature on the heating face becomes larger as a diameter is larger such as the above.

The thickness of the ceramic substrate of the ceramic heater of the present invention is desirably 25 mm or less . This is because if the thickness of the ceramic substrate is more than 25 mm, the temperature following character thereof deteriorates.

The thickness is desirably more than 1.5 mm, and 5 mm or less. This is because: if the thickness is more than 5 mm, heat does not conduct easily thus to generate a tendency that heating efficiency deteriorates; and if the thickness is 1.5 mm or less, a temperature scattering on the heating face may be generated since heat conducting in the ceramic substrate does not diffuse sufficiently, or the strength of the ceramic substrate may drop so that the ceramic substrate may be broken.

In the ceramic heater of the present invention, a ceramic is used as the material of the substrate. The ceramic is not particularly limited. Examples thereof include nitride ceramics, carbide ceramics, oxide ceramics and the like.

Among these ceramics, nitride ceramics and carbide ceramics are preferable as the materials of the ceramic substrate. This is because they have a high thermal conductivity.

Examples of the nitride ceramics include aluminum nitride, silicon nitride, boron nitride, titanium nitride and the like. Examples of the carbide ceramics include silicon carbide, titanium carbide, boron carbide and the like. Examples of the oxide ceramics include alumina, cordierite, mullite, silica, beryllia and the like. These ceramics may be used alone or in combination of two or more thereof.

Among these ceramics , aluminum nitride is most preferable since its thermal conductivity is highest, that is, 180 W/m • K.

However, in order that the ceramic substrate does not absorb a laser ray, the following contrivances are necessary: the amount of carbon therein is made small; the Ra according to JIS B0601 is set to 10 µm or less by grinding the surface; and the like. If necessary, a heat-resistant ceramic layer may be formed between the resistance heating element and the ceramic substrate. For example, in the case of a non-oxide type ceramic, an oxide ceramic may be formed on the surface thereof.

The resistance heating element formed on or inside the ceramic substrate is desirably divided into at least two or more circuits. By the division into the circuits, electric power supplied to the respective circuits (channels) can be controlled to change the calorific value thereof so that the temperature of the heated surface of a silicon wafer can be adjusted. The number of the circuit(s) is desirably less than 15. This is because the control thereof is easy. In the present invention, the number of the circuit(s) can be made as small as less than 15 since a scattering in the resistance value can be made small.

Examples of the pattern of the resistance heating elements include concentric circuits, a spiral, eccentric circuits, and winding lines. The pattern in the form of concentric circuits, as illustrated in Fig. 1, or a combination of the form of concentric circuits and the form of winding lines is preferred since the pattern makes it possible to make the temperature of the entire ceramic substrate even.

As the method of forming the resistance heating elements on the surface of the ceramic substrate, the above-mentioned method is used. That is : a conductor containing paste is applied to given areas on the ceramic substrate, thus a conductor containing paste layer is formed, and subsequently a trimming treatment with a laser is performed to form resistance heating elements having a given pattern; or a conductor containing paste is baked and subsequently a trimming treatment with a laser is performed to form resistance heating elements having a given pattern. By firing, metal particles can be sintered on the surface of the ceramic substrate. The metal sintering is sufficient if the metal particles are melted and adhered to each other and the metal particles and the ceramic are melted and adhered to each other. The metal particles adhere closely to the ceramic substrate through an oxide called glass frit. Trimming is optimally performed after the firing. This is because the resistance value can be more precisely controlled after the firing since the resistance value is varied by the firing.

A method such as plating or sputtering may be used to form a conductor layer in given areas, and then the layer may be subjected to a trimming treatment with a laser.

When the resistance heating elements are formed on the surface of the ceramic substrate, the thickness of the resistance heating elements is preferably from 1 to 30 µm and more preferably from 1 to 15 µm. The width of the resistance heating elements is preferably from 0.5 to 20 mm and more preferably from 0.5 to 5 mm.

The resistance value of the resistance heating elements can be changed dependently on their width or thickness. The above-mentioned ranges are however most practical. The resistance value (volume resistivity) can be adjusted by the use of a laser ray, as described above.

The resistance heating elements may have a rectangular section, a semicircular section, or an elliptical section. They desirably have a flat section. In the case of the flat section, heat is more easily radiated toward the heating face. Thus, a temperature distribution on the heating face is not easily generated.

The aspect ratio (the width of the resistance heating element/the thickness of the resistance heating element) of the section is desirably from 10 to 5000.

This is because adjustment thereof into this range makes it possible to increase the resistance value of the resistance heating elements and keep the evenness of the temperature on the heating face.

In the case that the thickness of the resistance heating elements is made constant, the amount of heat conduction toward the heating face of the ceramic substrate becomes small if the aspect ratio is smaller than the above-mentioned range. Thus, a thermal distribution similar to the pattern of the resistance heating elements is generated on the heating face. On the other hand, if the aspect ratio is too large, the temperature of the portions just above the centers of the resistance heating elements becomes high so that a thermal distribution similar to the pattern of the resistance heating elements is generated on the heating face after all. Accordingly, if temperature distribution is considered, the aspect ratio of the section is preferably from 10 to 5000.

The conductor containing paste is not particularly limited, and is preferably a paste comprising not only metal particles or a conductive ceramic for keeping electrical conductivity but also a resin, a solvent, a thickener and so on.

The above-mentioned metal particles are preferably made of, for example, a noble metal (gold, silver, platinum or palladium), lead, tungsten, molybdenum, nickel and the like. These may be used alone or in combination of two or more. This is because these metals are not relatively easily oxidized, and have a resistance value sufficient for generating heat.

Examples of the above-mentioned conductive ceramic include carbides of tungsten and molybdenum. These may be used alone or in combination of two or more.

The particle diameter of these metal particles or the conductive ceramic particles is preferably from 0.1 to 100 µm. If the particle diameter is too fine, that is, below 0.1 µm, they are easily oxidized. On the other hand, if the particle diameter is over 100 µm, they are not easily sintered so that the resistance value becomes large and further the paste is not easily printed.

The shape of the metal particles may be spherical or scaly. When these metal particles are used, they may be a mixture of spherical particles and scaly particles. In the case that the metal particles are scaly or a mixture of spherical particles and scaly particles, metal oxides between the metal particles are easily held and adhesion between the resistance heating elements and the nitride ceramic and the like is made sure. Moreover, the resistance value can be made large. Thus, this case is profitable.

Examples of the resin used in the conductor containing paste include an epoxy resin and a phenol resin. Example of the solvent include isopropyl alcohol, butyl carbitol and diethylene ether monoethyl ether. An example of the thickener is cellulose.

It is desirable to add a metal oxide to the metal particles in the conductor containing paste and make a sintered body of the resistance heating elements, the metal particles and the metal oxide (glass frit). By sintering the metal oxide together with the metal particles in this way, the nitride ceramic and the like which constitutes the ceramic substrate can be closely adhered to the metal particles.

The reason why the adhesion to the nitride ceramic and the like by mixing the metal oxide is improved is unclear, but would be based on the following. The surface of the metal particles, or the surface of the nitride ceramic and the like is slightly oxidized so that an oxidized film is formed thereon. Pieces of this oxidized films are sintered and integrated with each other through the metal oxide so that the metal particles and the nitride ceramic and the like are closely adhered to each other. In the case that the ceramic constituting the ceramic substrate is an oxide ceramic, the surface thereof is naturally made of the oxide. Therefore, a conductor layer having excellent adhesion is formed.

A preferred example of the above-mentioned metal oxide is at least one selected from the group consisting of lead oxide, zinc oxide, silica, boron oxide (B₂O₃), alumina, yttria, and titania.

This is because these oxides make it possible to improve adhesion between the metal particles and the nitride ceramic and the like without increasing the resistance value of the resistance heating elements 12 too much.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The weight ratio is desirably adjusted within the scope that the total thereof is not over 100 parts by weight.

By adjusting the amounts of these oxides within these ranges, particularly adhesion to the nitride ceramic and the like can be improved.

The addition amount of the metal oxides to the metal particles is preferably from 0.1 % by weight or more and less than 10 % by weight. The area resistivity when the conductor containing paste having such a structure is used to form the resistance heating elements 12 are preferably from 1 mΩ/□ to 50 mΩ/□.

This is because if the area resistivity is more than 50 mΩ/□, the calorific value for an applied voltage becomes too large so that, in the ceramic substrate 11 wherein the resistance heating elements 12 are set on its surface, its calorific value is not easily controlled. Incidentally, if the addition amount of the metal oxides is 10 % or more by weight, the area resistivity exceeds 50 mΩ/□ so that the calorific value becomes too large. Thus, temperature-control is not easily performed so that the evenness in temperature distribution deteriorates.

If necessary, the area resistivity can be set to 50 mΩ/□ to 10 Ω/□. If the area resistivity is made large, the width of the pattern can be made wide. Therefore, a problem of disconnection does not arise.

In the case that the resistance heating elements are formed on the surface of the ceramic substrate, a metal covering layer is preferably formed on the surfaces of the resistance heating elements. This is because the metal covering layer prevents a change in the resistance value based on oxidization of the inner metal sintered product. The thickness of the formed metal covering layer is preferably from 0.1 to 10 µm.

The metal used when the metal covering layer is formed is not particularly limited if the metal is a non-oxidizable metal. Specific examples thereof include gold, silver, palladium, platinum, nickel and the like. These may be used alone or in combination of two or more. Among these metals, nickel is preferred.

For the covering layer, an inorganic insulating layer such as glass, a heat-resistant resistance resin, and the like can also be used.

The resistance heating elements need to have terminals for connection to a power source. The terminals are attached to the resistance heating element through solder. This is because nickel prevents thermal diffusion of the solder. As the connecting terminals, external terminals made of Kovar can be used.

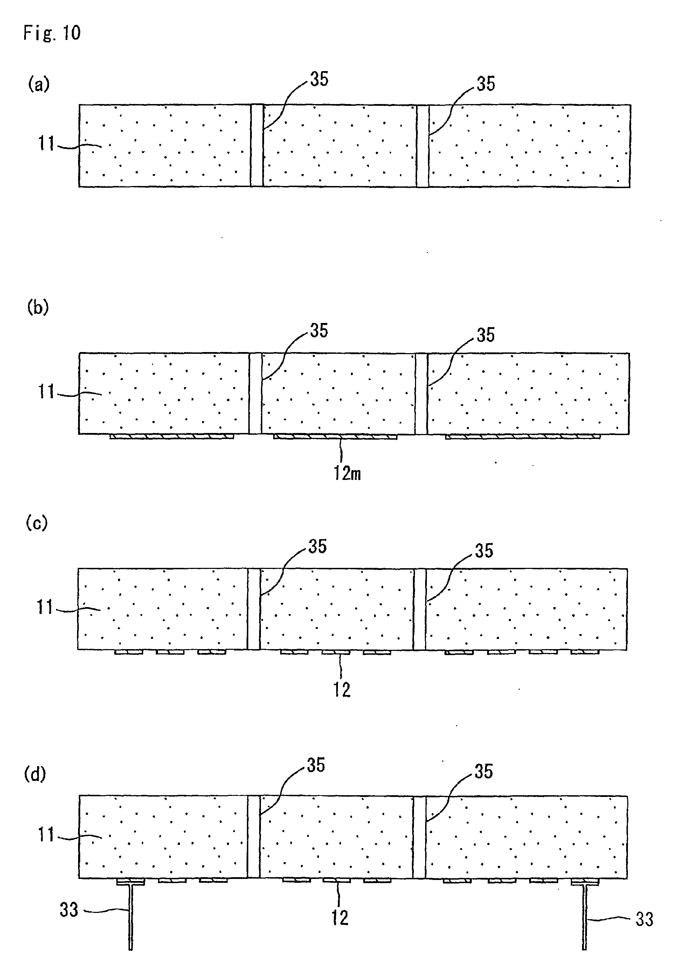

Referring to Figs. 10, about the process for manufacturing a ceramic heater of the present invention including a laser treatment, the following will describe steps other than a laser treatment step in more detail. Since the laser treatment step was previously described in detail, the step will briefly be described herein.

Figs. 10(a) to (d) are sectional views which schematically show some parts of the process for manufacturing a ceramic heater of the present invention including a laser treatment.

### (1) Step of forming a ceramic substrate

Powder made of a ceramic such as aluminum nitride and the like is blended with, if necessary, a sintering aid such as yttria (Y₂O₃), a binder and so on, to prepare a slurry. Thereafter, this slurry is made into a granular form by spray-drying and the like method. The granule is put into a mold and the like and pressed to be formed into a plate form and the like form. Thus, a raw formed body (green) is formed.

Next, portions which will be through holes 35, into which lifter pins 36 for carrying an object to be heated such as silicon wafer 39 and the like will be inserted; portions which will be bottomed holes, in which temperature-measuring elements such as thermocouples and the like will be embedded; and so on are made in the raw formed body if necessary.

Next, this raw formed body is heated and fired to be sintered. Thus, a plate-formed body made of the ceramic is manufactured. Thereafter, the plate-formed body is made into a given shape to manufacture a ceramic substrate 11 (reference to Fig. 10(a)). The shape of the raw formed body may be such a shape that the fired body can be used as it is. For example, by heating and firing the raw formed body while pressing the body from the upper and lower sides, the ceramic substrate 11 having no pores can be manufactured. It is sufficient that the heating and the firing are performed at sintering temperature or higher. The firing temperature is from 1000 to 2500 °C, for example, for a nitride ceramic.

Usually, after the firing, through holes 35, and bottomed holes (not illustrated) into which temperature-measuring elements will be inserted are made. The through holes 35 etc. can be made by drilling treatment such as sandblast with SiC particles and the like after grinding of the surface.

### (2) Step of printing a conductor containing paste on the ceramic substrate

A conductor containing paste is generally a fluid comprising metal particles, a resin and a solvent, and has a high viscosity. This conductor containing paste is printed in the whole of areas where resistance heating elements are to be arranged by screen printing and the like, to form a conductor containing paste layer 12m (Fig. 10 (b)).

Since it is necessary that the pattern of the resistance heating elements make the temperature of the whole of the ceramic substrate even, the pattern is desirably a pattern composed of concentric circles and winding lines, as shown in Fig. 3. The conductor containing paste layer is made into a pattern in the form of wide concentric circles or in the form of a circle, so as to include the above-mentioned pattern.

### (3) Firing of the conductor containing paste

The conductor containing paste layer printed on the bottom face of the substrate 11 is heated or fired to remove the resin and the solvent and sinter the metal particles . Thus , the metal particles are baked onto the bottom face of the ceramic substrate 11 to form a conductor layer having a given width (reference to Fig. 1). Thereafter, the above-mentioned trimming treatment with a laser is performed, to form resistance heating elements 12 having a given pattern (reference to Fig.10 (c)). The heating and firing temperature is preferably from 500 to 1000 °C.

It is allowable to form a pattern of concentric circles or a spiral, a winding pattern, and the like pattern firstly and perform trimming a part thereof to adjust the resistance value, thereby forming the resistance heating elements 12.

### (4) Formation of a metal covering layer

As illustrated in Fig. 2, a metal covering layer 120 is desirably formed on the surface of the resistance heating elements 12. The metal covering layer 120 can be formed by electroplating, electroless plating, sputtering and the like. Considering mass productivity, electroless plating is best. In Figs. 10, the metal covering layer 120 is not shown. The covering may be attained by glass, resin and the like instead of the metal.

### (5) Fitting of external terminals and so on

Terminals (external terminals 33) for connection to a power source are fitted up to ends of the pattern pieces of the resistance heating elements 12 with solder (reference to Fig. 10(d)). Thermocouples are fixed into the bottomed holes 34, and the bottomed holes are sealed with heat resistant resin such as polyimide and the like, so as to finish the manufacture of a ceramic heater.

The ceramic heater of the present invention can be used as an electrostatic chuck by setting up electrostatic electrodes inside the ceramic substrate, or can be used as a wafer prober by setting a chuck top conductor layer on the surface of the ceramic substrate and setting guard electrodes and ground electrodes inside.

The ceramic heater of the present invention can be used as an electrostatic chuck by setting up electrostatic electrodes inside the ceramic substrate, or can be used as a wafer prober by setting a chuck top conductor layer on the surface of the ceramic substrate and setting guard electrodes and ground electrodes inside.

### Best Mode for Carrying Out the Invention

The present invention will be described in more detail hereinafter.

### (Example 1) Manufacture of a ceramic heater (Figs. 1 and 2)

(1) A composition made of 100 parts by weight of aluminum nitride powder (average particle diameter: 0.6 µm), 4 parts by weight of yttria (average particle diameter: 0.4 µm), 12 parts by weight of an acrylic binder, and an alcohol was subjected to spray-drying to yield granular powder.
(2) Next, this granular powder was put into a mold and formed into a flat plate form, to obtain a raw formed body (green).
(3) Next, this raw formed body was hot-pressed at 1800 °C and a pressure of 20 MPa, to yield an aluminum nitride plate having a thickness of about 3 mm.
   Next, this plate-formed body was cut out into a disc having a diameter of 210 mm to prepare a plate-formed body made of the ceramic (ceramic substrate 11). This ceramic substrate was drilled to make through holes 35, into which lifter pins 36 for a silicon wafer would be inserted, and bottomed holes 34 (diameter: 1.1mm, and depth: 2mm), in which thermocouples would be embedded.
(4) A conductor containing paste layer was formed on the ceramic substrate 11 obtained in the above-mentioned (3) by screen printing. The printed pattern was a pattern as illustrated in Fig. 1.
   The used conductor containing paste was a paste having a composition of Ag: 48% by weight, Pt: 21% by weight, SiO₂: 1.0% by weight, B₂O₃: 1.2% by weight, ZnO: 4.1% by weight, PbO: 3.4% by weight, ethyl acetate: 3.4 % by weight, and butyl carbitol: 17.9% by weight.
   This conductor containing paste was a Ag-Pt paste. Silver particles thereof had an average particle diameter of 4.5 µm, and were scaly. Pt particles had an average particle diameter of 0.5 µm, and were spherical.
(5) Furthermore, the ceramic substrate 11 was heated and fired at 850 °C after the formation of the conductor containing paste layer for a heating element pattern, so as to sinter Ag and Pt in the conductor containing paste and bake Ag and Pt onto the substrate 11.
   The pattern of resistance heating elements had 7 channels 12a to 12g, as illustrated in Fig. 1. Table 1 describes the resistance values of the four channels in the periphery (resistance heating elements 12a to 12d) and a scattering thereof within each of the channels before trimming. Incidentally, a channel is a circuit to which the same voltage is applied in order to perform individual control. In the present example, however, the channel is each of the resistance heating elements (12a to 12d) formed as a continuous body.
   The resistance scattering within each of the channels (resistance heating elements 12a to 12d) was obtained: by dividing the channel into 20 pieces, measuring resistances at both ends of the respective divided areas, calculating the average thereof as an average divisional resistance value (noted as average value in Table 1); and further calculating a scattering from a difference between the highest resistance value and the lowest resistance value within the channel, and the average divisional resistance value. The resistance value of each of the channels (resistance heating elements 12a to 12d) is the summation of all resistance values measured in the each division of the channel.
(6) Next, as a trimming equipment, a YAG laser (S143AL made by NEC Corp., power: 5 W, and pulse frequency: 0.1 to 40 kHz) having a wavelength of 1060 nm was used. This equipment has an X-Y stage, a galvano mirror, a CCD camera, and a Nd:YAG laser, and has therein a controller for controlling the stage and the galvano mirror. The controller was connected to a computer (FC-9821, made by NEC Corp.). The computer has a CPU functioning as both of an operation unit and a memory unit. The computer also has a hard disc and a 3.5-inch FD driver functioning as a memory unit and an input unit.
   Heating element pattern data were inputted from the FD driver to this computer, and further the position of the conductor layer was readout (on the basis of markers, as standards, formed at specified positions in the conductor layer or in the ceramic substrate) . Necessary control data were calculated, and a laser was applied thereto in substantially parallel to the direction of current flowing through the heating element pattern, to remove a part of the conductor layer at which the laser was applied. In this way, gutters having a width of 50 µm were formed so that the gutters reached the ceramic substrate.
   The resistance heating elements had a thickness of 10 µm and a width of 2.4 mm. The laser had a frequency of 1 kHz, a power of 0.4 W, and a bite size of 10 µm. Working speed was 10 mm/second. The resistance values of the four channels in the periphery and a scattering thereof within each of the channels after the trimming are shown in Table 2. The resistance scattering within each of the channels was obtained by: dividing the channel into 20 pieces, measuring resistances at both ends of the divided areas, calculating the average thereof as an average divisional resistance value; and further calculating a scattering from a difference between the highest resistance value and the lowest resistance value within the channel, and the average divisional resistance value. The resistance value of each of the channels is the summation of all resistance values measured in the each division of the channel.
   Fig. 9 is a graph showing the shape (position and height) of a resistance heating element cross section including the gutter. As is evident from the data shown in Fig. 9, the gutter formed by the trimming reaches the ceramic substrate. The sectional shape was measured by means of a laser displacement meter made by Keyence Co.
(8) Next, portions to which external terminals 33 for ensuring connection to a power source would be fitted were subjected to Ni plating, and subsequently a silver-lead solder paste (made by Tanaka Noble Metal) was printed by screen printing, so as to form a solder layer.
   Next, the external terminals 33 made of Kovar were put on the solder layer, and heated and reflowed at 420 °C to fit the external terminals 33 to the surface of the resistance heating elements 12.
(9) Thermocouples for controlling temperature were sealed with polyimide, to yield a ceramic heater 10.

### (Example 2)

A ceramic heater was manufactured in the same way as in Example 1 except that a ceramic substrate was manufactured as follows.
(1) A composition made of 100 parts by weight of SiC powder (average particle diameter: 1.1 µm), 4 parts by weight of B₄C, 12 parts by weight of an acrylic binder, and an alcohol was subjected to spray-drying to yield granular powder.
(2) Next, this granular powder was put into a mold and formed into a flat plate form to obtain a raw formed body (green).
(3) Next, this raw formed body was hot-pressed at 1890°C and a pressure of 20 MPa, to yield a SiC plate-formed body having a thickness of about 3 mm. Furthermore, the surface was ground with a diamond grindstone of #800, and polished with a diamond paste to set the Ra thereof to 0.008 µm. Furthermore, the surface was coated with a glass paste (G-5177, made by Shoei Chemical Industries Co., Ltd.) , and the temperature of the resultant was raised to 600 °C. In this way, a SiO₂ layer having a thickness of 2 µm was formed.

Next, this plate-formed body was cut out into a disc having a diameter of 210 mm to prepare a plate-formed body made of the ceramic (ceramic substrate 11). This ceramic substrate was drilled to make through holes 35, into which lifter pins 36 for a silicon wafer would be inserted, and bottomed holes 34 (diameter: 1.1mm, and depth: 2mm), in which thermocouples would be embedded.

### (Comparative Example 1)

The same manner as in Example 1 was performed, but trimming was carried out, plural times, perpendicularly to the direction of current flowing through the resistance heating elements.

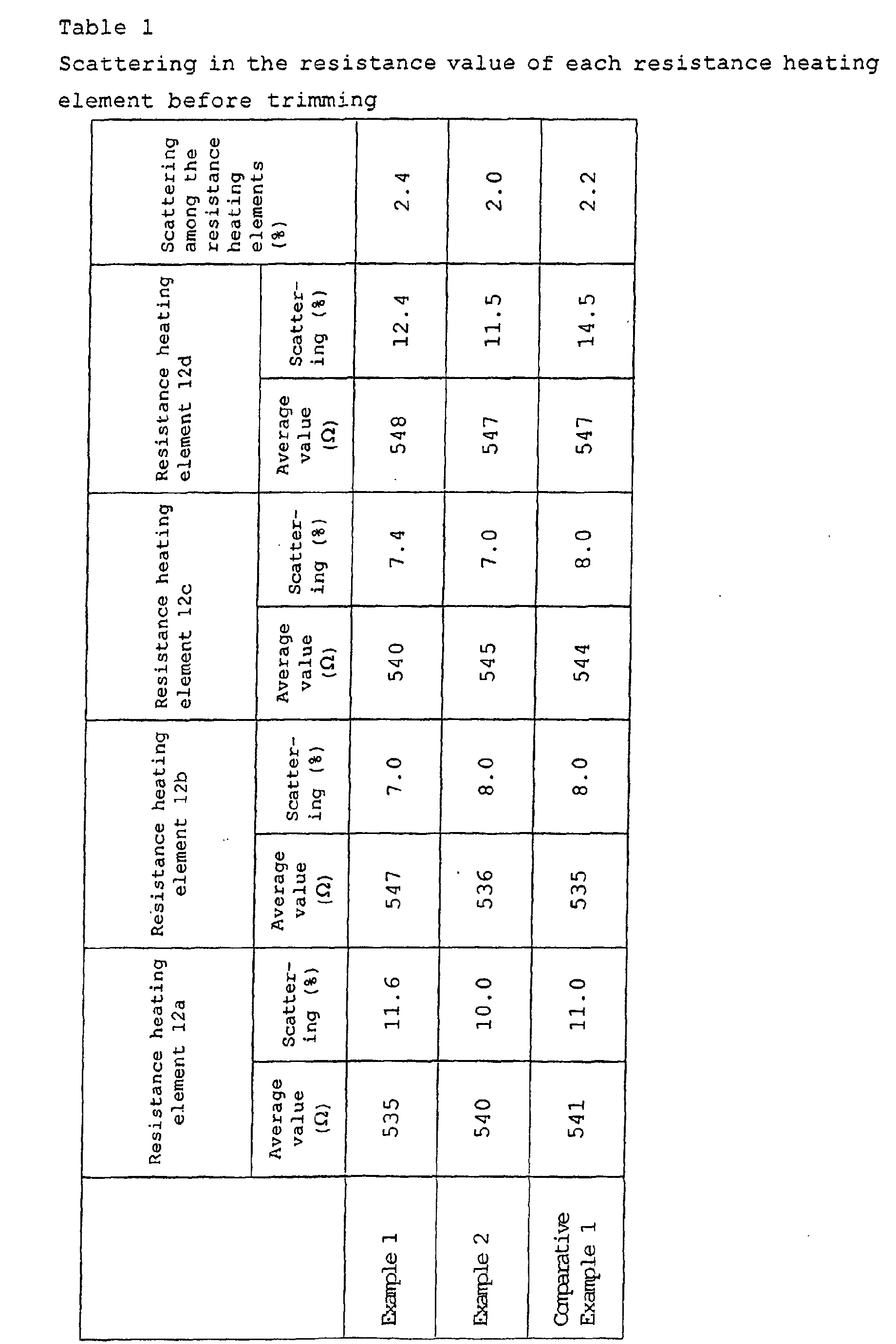

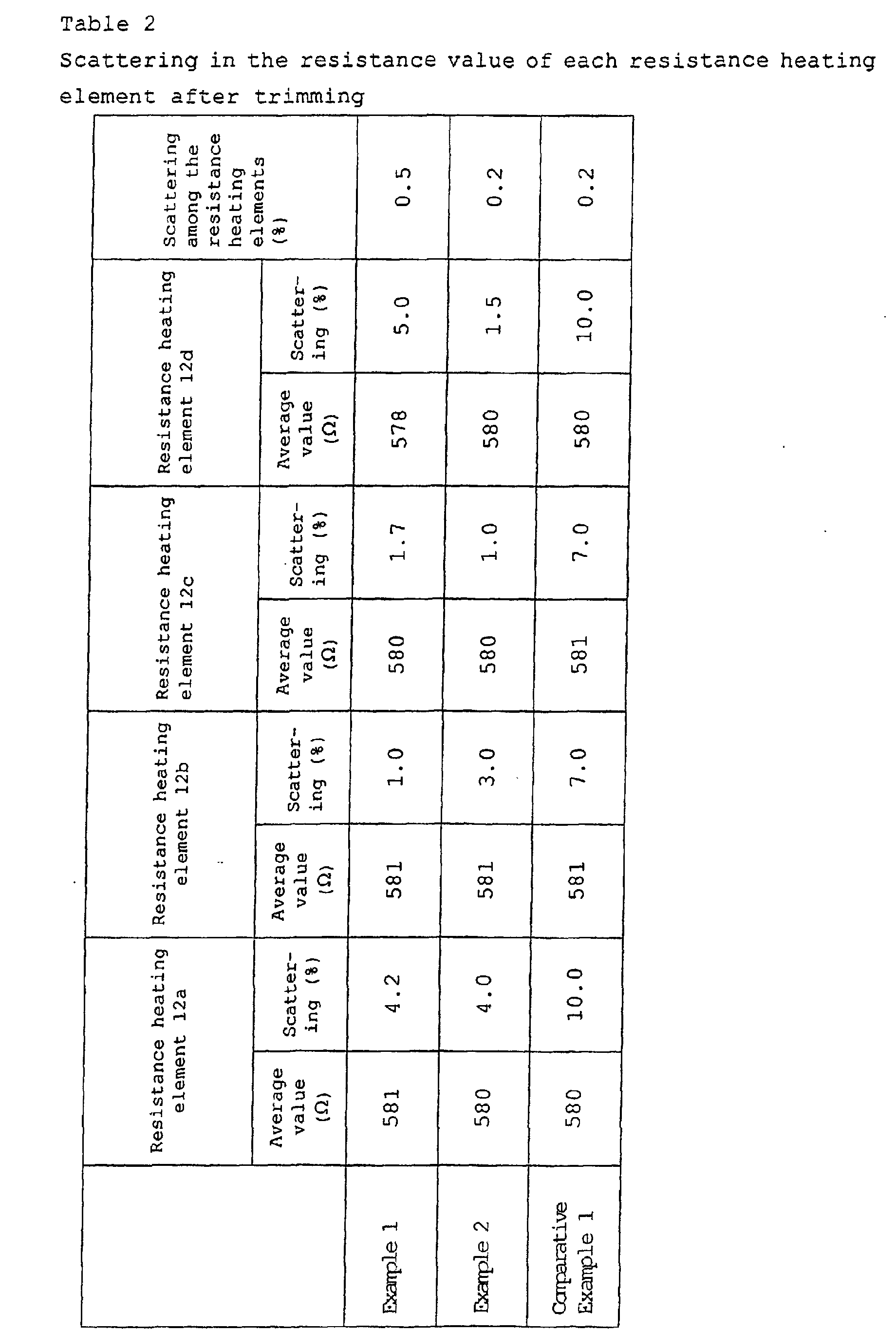

The ceramic heaters obtained through the above-mentioned steps were evaluated in accordance with the following indexes.

At this time, a temperature-adjusting equipment (E5ZE, made by Omron Corp.) were fitted to the heaters manufactured in Examples 1 to 2 and Comparative Example 1, and the following performance evaluations were carried out.

### (1) Evenness of a distribution of temperature on the heating face

A silicon wafer to which 17-point temperature-measuring elements were fitted was used to measure a distribution of the in-face temperature of each heater. The temperature distribution is indicated by a difference between the highest temperature and the lowest temperature when the temperature of the wafer is set at 200 °C.

### (2) Evenness of the in-face temperature at a transient time

A distribution of the in-face temperature was measured when the temperature of each heater was raised from room temperature to 130 °C. The temperature distribution was indicated by a difference between the highest temperature and the lowest temperature.

### (3) Over shooting degree

The temperature of each heater was raised to 200 °C, then the following was measured, that is: how much at most the temperature rise from 200 °C before the temperature arrives at a stationary temperature.

### (4) Recovery period

In the case that the temperature set was 140 °C and a silicon wafer of 25 °C was put on each heater, a period until the temperature of each heater recovered to 140 °C was measured.

The results are shown in Figs. 3 and 4.

**Table 3**

| | Distribution of the in-face temperature (°C) | Distribution of the in-face temperature at a transient time (°C) |
|---|---|---|
| Example 1 | 0.3 | 3.1 |
| Example 2 | 0.3 | 5.0 |
| Comparative Example 1 | 1.0 | 8.0 |

**Table 4**

| | Over shooting degree (°C) | Recovery period (seconds) |
|---|---|---|
| Example 1 | 0.3 | 25 |
| Example 2 | 0.3 | 25 |
| Comparative Example 1 | 2.0 | 35 |

It is clear from the results shown in Tables 1 and 2 that in Examples 1 and 2, the scatterings in the resistance value of the resistance heating elements 12a to 12d after the trimming were about 5% or less (1% in the heater having the highest precision) within each of the channel: and those after the trimming was as good as 0.5% or less on the heating face. Moreover, no resistance heating elements melted.

On the other hand, it was proved that in Comparative Example 1, the scattering was 7% or more even within each of the channel, and the resistance heating elements melted.

Also, as is evident from the results shown in Tables 3 and 4, in Examples 1 and 2, since the resistance scattering within the channel and the resistance scattering among the channels were not generated after the trimming, the in-face temperature evenness was excellent in the stationary period and at a transient time. Further, since the resistance value was even, temperature-control is easy. The over shooting temperature was also low and the recovery period was also short.

On the other hand, in Comparative Example 1, the resistance scattering within the channel could not be made small. Therefore, the in-face temperature evenness was poor at the stationary period and at a transient time. The temperature-control property was poor. The over shooting temperature was also high and the recovery period was also long.

In Comparative Example 1, control based on the 7 channels was not successful. It is necessary to increase the number of the channels and perform control by varying applied power source thereto.

Furthermore, in Comparative Example 1, the resistance value rose locally so that excessive heat was generated. As a result, the resistance heating elements melted so that some of them disconnected.

### Industrial Applicability

As described above, according to the present invention, a scattering in the resistance value of a resistance heating element is hardly generated. Therefore, a ceramic heater having a heating face excellent in temperature evenness can be obtained. Also, the resistance heating element is not melted by heating. Additionally, the number of channels can be reduced, and in-face temperature evenness at a transient time can be improved. The recovery period can also be made short.

## Claims

1. A ceramic heater, for a semiconductor producing/examining device, comprising a ceramic substrate and a resistance heating element formed on a surface thereof,
wherein a gutter is formed along the direction of current flowing through the resistance heating element.

2. The ceramic heater for a semiconductor producing/examining device according to claim 1,
wherein said gutter has a depth of 20% or more of the thickness of the resistance heating element.

3. The ceramic heater for a semiconductor producing/examining device according to claim 1 or 2,
wherein a resistance value scattering in said resistance heating element to the average resistance value of said resistance heating element is 5% or less.
